# EUROPEAN PATENT SPECIFICATION

(11) **EP 2 617 770 B1**
(45) Date of publication and mention of the grant of the patent: **07.01.2015**
(21) Application number: 13151612.2
(22) Date of filing: 17.01.2013
(51) Int. Cl.: C08L 63/00, H01L 21/56, H01L 23/00

(54) **Resin composition sheet for encapsulating electronic parts and method of producing electronic part apparatus using the sheet**
Harzzusammensetzungsfolie zum Verkapseln elektronischer Teile und Verfahren zur Herstellung einer Vorrichtung aus elektronischen Teilen unter Verwendung der Folie
Feuille de composition de résine pour l'encapsulation de pièces électroniques et procédé de production d'un dispositif de pièce électronique utilisant la feuille

(30) Priority: 20.01.2012 JP 2012010146
(43) Date of publication of application: 24.07.2013
(73) Proprietor: Nitto Denko Corporation, Osaka 567-8680 (JP)
(72) Inventor: Toyoda, Eiji, Osaka 567-8680 (JP); Shimizu, Yusaku, Osaka 567-8680 (JP); Matsumura, Takeshi, Osaka 567-8680 (JP)
(74) Representative: Hoffmann Eitle

(56) References cited:
- EP-A1- 1 992 671
- JP-A- 2006 019 714

## Description

### BACKGROUND OF THE INVENTION

### 1. Field of the Invention

The present invention relates to a resin composition sheet for easily encapsulating an electronic part, protecting, and reinforcing a surface of a mounted substrate on which various electronic parts such as a semiconductor element are mounted, and to a method of producing an electronic part apparatus using the sheet.

### 2. Description of the Related Art

In association with a reduction in size of electronic equipment and an improvement in functionality thereof, the number of products that are each modularized by placing various devices (electronic parts such as a semiconductor element, a capacitor, and a resistance element) having individual functions on one substrate has been increasing in recent years. Under such circumstances, the reliability of each of the products as a module has been secured by encapsulating a circuit substrate on which various electronic devices having different heights are mounted with a resin.

For example, transfer molding, or coating or potting with a liquid resin has been performed as the encapsulation method involving using the resin. However, the transfer molding involves such problems as described below: an apparatus for the transfer molding such problems as described below: an apparatus for the transfer molding is expensive; a die matched with a product shape is needed; and the thickness of a resin at the time of the encapsulation needs to be matched with a part having the highest height, with the result that the amount of the resin increases and the final product becomes heavy. Meanwhile, the liquid resin also involves problems such as the sagging of the resin to the outside of a substrate, the contamination of a jig or the like, the occurrence of unsealed portions at an edge of a part and a side surface portion thereof, and the difficulty with which a uniform encapsulation thickness is obtained. In view of the foregoing, various encapsulation methods each involving using a sheet-shaped resin have been proposed in recent years (see JP-A-2004-327623, JP-A-2006-19714, and JP-A-2003-145687, and Japanese Patent No. 4,593,187 and Japanese Patent No. 4,386,039).

However, such encapsulation with the sheet-shaped resin requires the pressing of the sheet-shaped resin. Accordingly, when surface unevenness is large owing to, for example, the fact that the heights of various devices placed on a substrate are not aligned with each other, it is difficult to uniformly seal and protect the entire surface, and hence a void or an unsealed portion has occurred in some cases.

Not only a thin surface-mount device but also miscellaneous electronic devices having different heights have been mounted on a module substrate called an electronic control unit (ECU) among any other semiconductor package or ceramic capacitor is mounted on the substrate in many cases. Accordingly, the substrate involves a problem in that it is particularly difficult to seal and protect the entire surface of the substrate with the sheet-shaped resin. In the surface protection of such electronic substrate, the encapsulation and protection of the substrate have been performed by, for example, a method involving applying a liquid moisture-proof coating material. However, it has been desired that the encapsulation and protection be performed more easily and with higher reliability (see JP-A-2011-89061).

### SUMMARY OF THE INVENTION

A resin composition sheet for encapsulating an electronic part capable of encapsulating and protecting a mounted substrate having large unevenness easily, at a low cost, and with high reliability, and a method of producing an electronic part apparatus using the sheet are provided.

A first gist is a resin composition sheet for encapsulating electronic parts, including a thermosetting resin composition containing an epoxy resin, a phenol resin, an inorganic filler, and a curing accelerator, the thermosetting resin composition having a lowest viscosity in temperature increase measurement with a viscoelasticity-measuring apparatus in a range of 100 to 20,000 Pa·s, in which the sheet has a thickness in a range of 20 to 200 µm.

In addition, a secondgist is amethodof producing anelectronic part apparatus, including: arranging and mounting a plurality of electronic parts on a circuit substrate to provide a mounted substrate, followed by loading of a resin composition sheet described in the following item (A), in a state where the sheet covers upper surfaces of the electronic parts; heating the mounted substrate after the loading of the sheet in a chamber in a decompressed state to sag an end portion of the perimeter of the sheet through thermal softening until the end portion is in contact with a surface of the substrate to enclose a space surrounded with the perimeter of the sheet; releasing a pressure in the chamber to cause the sheet to closely adhere onto the mounted substrate due to a difference between (i) a pressure in the enclosed space formed between the sheet and the mounted substrate, and (ii) the pressure in the chamber after the release to seal the electronic parts; and thermally curing the sheet after the encapsulation:
(A) a resin composition sheet for encapsulating electronic parts including a thermosetting resin composition containing, as essential components, an epoxy resin, a phenol resin, an inorganic filler, and a curing accelerator, the thermosetting resin composition having a lowest viscosity in temperature increase measurement with a viscoelasticity-measuring apparatus in a range of 100 to 20,000 Pa·s, the sheet having a thickness in a range of 20 to 200 µm.

A resin composition sheet for encapsulating an electronic parts capable of performing encapsulation excellent in unevenness followability on a mounted substrate in which electronic parts having various heights are simultaneously present through heating without performing a pressing step (pressing from above a encapsulation sheet) that has been conventionally needed in encapsulating with a sheet-shaped resin was obtained. The resin composition sheet includes a thermosetting resin composition containing an epoxy resin, a phenol resin, an inorganic filler, and a curing accelerator, the thermosetting resin composition having a lowest viscosity in temperature increase measurement with a viscoelasticity-measuring apparatus in a range of 100 to 20, 000 Pa·s, the sheet having a thickness in a range of 20 to 200 µm.

The sheet loaded on the mounted substrate is heated in a chamber in a decompressed state so that the end portion of the perimeter of the sheet may be sagged through thermal softening until the end portion is in contact with the surface of the substrate. After that, the pressure in the chamber is released to cause the sheet to closely adhere onto the mounted substrate due to a difference between the pressure in the enclosed space formed between the sheet and the mounted substrate, and the pressure in the chamber after the release. Then, in the state, the sheet is thermally cured to seal the electronic parts. Particularly when the foregoing approach is adopted in a method of producing an electronic part apparatus using the sheet, the characteristics of the sheet are taken advantage of, and hence encapsulation excellent in unevenness followability can befavorably performed on the mounted substrate in which electronic parts having various heights are simultaneously present without the pressing step.

As described above, the resin composition sheet for encapsulating electronic parts of the present invention includes a thermosetting resin composition containing an epoxy resin, a phenol resin, an inorganic filler, and a curing accelerator, the thermosetting resin composition having a lowest viscosity in temperature increase measurement with a viscoelasticity-measuring apparatus in a range of 100 to 20,000 Pa·s, in which the sheet has a thickness in a range of 20 to 200 µm. Accordingly, encapsulation excellent in unevenness followability can be performed on a mounted substrate in which electronic parts having various heights are simultaneously present through heating without the performance of a pressing step that has been conventionally needed.

In addition, in the method of producing an electronic part apparatus, electronic parts are sealed as described below. The special sheet loaded on the mounted substrate is heated in a chamber in a decompressed state so that the end portion of the perimeter of the sheet may be sagged through thermal softening until the end portion is in contact with the surface of the substrate. After that, the pressure in the chamber is released to cause the sheet to closely adhere onto the mounted substrate due to a difference between the pressure in the enclosed space formed between the sheet and the mounted substrate, and the pressure in the chamber after the release, followed by thermal curing. Accordingly, even a mounted substrate having large unevenness can be securely sealed and protected easily, at a low cost, and with high reliability without the use of a die, a film for pressing, or the like and without the pressing step.

### BRIEF DESCRIPTION OF THE DRAWINGS

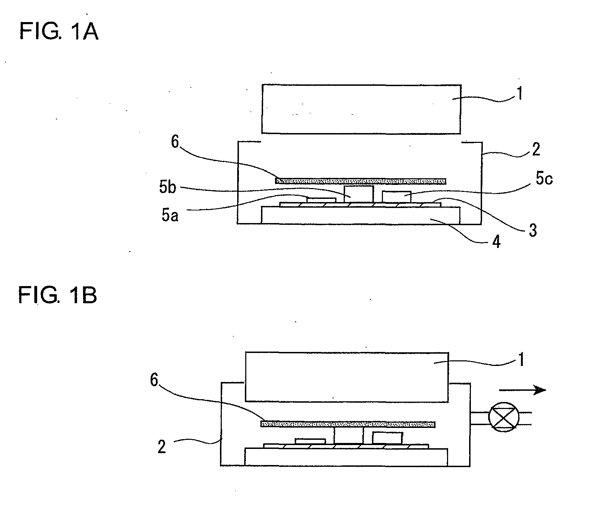

FIGS. 1A and 1B are each an explanatory diagram illustrating a resin encapsulation step in a method of producing an electronic part apparatus of the present invention, FIG. 1A being a diagram illustrating a state where a sheet of the present invention is loaded on a mounted substrate on which electronic parts are mounted, and FIG. 1B being a diagram illustrating a state where the sheet of the present invention is heated in a chamber in a decompressed state; and

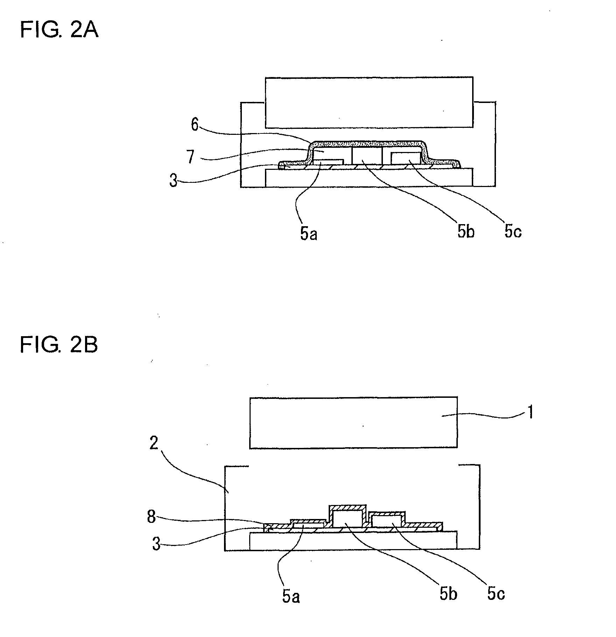

FIGS. 2A and 2B are each an explanatory diagram illustrating the resin encapsulation step in the method of producing an electronic part apparatus of the present invention, FIG. 2A being a diagram illustrating a state where the end portion of the sheet of the present invention is sagged by the decompression and heating of FIG. 1B until the end portion is in contact with the mounted substrate, and FIG. 2B being a diagram illustrating a state where a pressure in the chamber is released and the sheet of the present invention is thermally cured to seal the electronic parts.

### DETAILED DESCRIPTION OF THE INVENTION

Next, an embodiment of the present invention is described in detail.

As describedabove, a resin composition sheet for encapsulating electronic parts (hereinafter, simply abbreviated as "sheet" as required) includes a thermosetting resin composition containing an epoxy resin, a phenol resin, an inorganic filler, and a curing accelerator, the thermosetting resin composition having a lowest viscosity in temperature increase measurement with a viscoelasticity-measuring apparatus in the range of 100 to 20,000 Pa·s, in which the sheet has a thickness in the range of 20 to 200 µm.

Hereinafter, materials as the respective ingredients of the sheet, the features defined above, and the like are described in detail.

### (Epoxy resin)

Examples of the epoxy resin as a material for the thermosetting resin composition constituting the sheet include various epoxy resins such as a triphenylmethane type epoxy resin, a cresol novolac type epoxy resin, a biphenyl type epoxy resin, a modified bisphenol A type epoxy resin, a bisphenol A type epoxy resin, a bisphenol F type epoxy resin, a modified bisphenol F type epoxy resin, a dicyclopentadiene type epoxy resin, a phenol novolac type epoxy resin, and a phenoxy resin. One kind of those various epoxy resins is used alone, or two or more kinds thereof are used in combination. Of those, a crystalline epoxy resin such as a biphenyl type epoxy resin or a bisphenol F type crystalline epoxy resin, or a modified bisphenol A type epoxy resin is preferred from the viewpoint of the flexibility of an encapsulation sheet produced from the resin.

### (Phenol resin)

In addition, the phenol resin to be used together with the epoxy resin is not particularly limited as long as the phenol resin causes a curing reaction with the epoxy resin, and examples thereof include a phenol novolac resin, a phenol aralkyl resin, a biphenyl aralkyl resin, a dicyclopentadiene type phenol resin, a cresol novolac resin, and a resol resin. One kind of those various phenol resins is used alone, or two or more kinds thereof are used in combination.

### (Inorganic filler)

In addition, examples of the inorganic filler to be used together with the epoxy resin and the phenol resin include quartz glass powder, talc, silica powders (such as a molten silica powder and a crystalline silica powder), alumina powder, aluminum nitride powder, and silicon nitride powder. One kind of those various inorganic fillers is used alone, or two or more kinds thereof are used in combination. Of those, the silica powders are preferred from the following viewpoints. A cost reduction can be achieved and the internal stress of a cured body of the resin composition can be reduced by lowering its thermal linear expansion coefficient. Further, the molten silica powder out of the silica powders is more preferably used from the viewpoints of high filling property and high flowability.

Examples of the molten silica powder include spherical molten silica powders and crushed molten silica powders. The spherical molten silica powders are particularly preferably used from the viewpoint of flowability. Of those, a powder having an average particle diameter in the range of 0.1 to 30 µm is preferably used, and a powder having an average particle diameter in the range of 0.3 to 15 µm is particularly preferably used. It should be noted that the average particle diameter can be derived by, for example, measuring a sample arbitrarily sampled from a population with a laser diffraction/scattering type particle size distribution-measuring apparatus

### (Curing accelerator)

In addition, the curing accelerator to be used together with the epoxy resin, the phenol resin, and the inorganic filler is not particularly limited as long as the curing accelerator advances the curing of the epoxy resin and the phenol resin. An organophosphorus compound such as triphenylphosphine or tetraphenylphosphonium tetraphenylborate, or an imidazole-based compound is preferably used from the viewpoints of curability and storage stability. One kind of those various curing accelerators is used alone, or two or more kinds thereof are used in combination.

### (Other materials)

A flexibilizer (such as an elastomer), a flame retardant, a pigment typified by carbon black, or the like can be appropriately blended as required as a material for the thermosetting resin composition constituting the sheet in addition to the epoxy resin, the phenol resin, the inorganic filler, and the curing accelerator described in the foregoing.

As the elastomer, there is used, for example, any of various acrylic copolymers such as a polyacrylic acid ester, elastomers each having a styrene skeleton such as a polystyrene-polyisobutylene-based copolymer and a styrene acrylate-based copolymer, and rubbery polymers such as a butadiene rubber, a styrene-butadiene rubber (SBR), an ethylene- vinyl acetate copolymer (EVA), an isoprene rubber, and an acrylonitrile rubber.

### (Lowest viscosity and method of adjusting the viscosity)

As described in the foregoing, the lowest viscosity of the thermosetting resin composition constituting the sheet in temperature increase measurement with a viscoelasticity-measuring apparatus needs to be set within the range of 100 to 20,000 Pa·s, and the lowest viscosity is set within the range of preferably 500 to 18, 000 Pa·s, more preferably 1, 000 to 15,000 Pa·s. That is because setting the lowest viscosity within the range enables encapsulation excellent in unevenness followability on a mounted substrate in which electronic parts having various heights are simultaneously present through heating without the performance of a pressing step that has been conventionally needed in the encapsulation with a sheet-shaped resin. It should be noted that the lowest viscosity is determined, for example, by: cutting a disc-shaped sheet piece having a thickness of 1 mm and a diameter of 8 mmΦ out of a sheet formed of the thermosetting resin composition; and subjecting the sheet piece to temperature increase measurement with a viscoelasticity-measuring apparatus (ARES manufactured by TA Instruments) at a rate of temperature increase of 10°C/min and a measuring frequency of 1 Hz from 40°C to 150°C to measure its lowest storage viscosity value (lowest viscosity).

It should be noted that the lowest viscosity can be regulated depending on, for example, the amount of the inorganic filler or flexibilizer (such as the elastomer) in the thermosetting resin composition. In ordinary cases, the lowest viscosity is raised by increasing the ratio of the inorganic filler or the flexibilizer to the entirety of the thermosetting resin composition, and the lowest viscosity is lowered by reducing the ratio of the inorganic filler or the flexibilizer.

In addition, for example, when a crystalline epoxy resin is used as the epoxy resin as a material for the thermosetting resin composition constituting the sheet, a resin composition whose lowest viscosity falls within the specific range can be obtained by: setting the blending amount of the inorganic filler to 80 to 92 wt% of the entirety of the resin composition; and setting the blending amount of the elastomer to 10 to 50 wt% of the entirety of the organic components in the resin composition. It should be noted that the blending amount of the elastomer preferably falls within the range of 20 to 40 wt% and more preferably falls within the range of 25 to 35 wt%.

In addition, when a modified bisphenol A type epoxy resin is used as the epoxy resin as a material for the thermosetting resin composition constituting the sheet, a resin composition whose lowest viscosity falls within the specific range can be obtained by: setting the blending amount of the inorganic filler to 40 to 80 wt% of the entirety of the resin composition; and setting the blending amount of the elastomer to 30 to 80 wt% of the entirety of the organic components in the resin composition. It should be noted that the blending amount of the elastomer preferably falls within the range of 50 to 75 wt% and more preferably falls within the range of 60 to 70 wt%.

Although the lowest viscosity can be set within the specific range by, for example, adjusting the blending amount of the inorganic filler without blending the flexibilizer such as the elastomer into the thermosetting resin composition constituting the sheet as described above, the elastomer is preferably used in combination as described above from the viewpoints of the characteristics of the cured product of the resin composition.

When a crystalline epoxy resin is used as the epoxy resin as a material for the thermosetting resin composition constituting the sheet, an elastomer having a styrene skeleton, in particular, a polystyrene-polyisobutylene-based copolymer is preferably used as the elastomer. In addition, when a modified bisphenol A type epoxy resin is used as the epoxy resin as a material for the thermosetting resin composition constituting the sheet, any one of the various acrylic copolymers is preferably used as the elastomer.

### (Method of producing sheet)

The resin composition sheet for encapsulating electronic parts can be produced, for example, as described below. That is, first, the respective materials for the sheet described in the foregoing are uniformly dispersed and mixed to prepare the resin composition. Then, the prepared resin composition is formed into a sheet shape. Examples of the forming method include: a method involving extruding the prepared resin composition into a sheet shape; and a method involving dissolving or dispersing the prepared resin composition in an organic solvent or the like to prepare a varnish, coating the top of a base material made of a polyester or the like with the varnish, and drying the varnish to produce the sheet. It should be noted that a release sheet such as a polyester film may be attached to the surface of the resin composition sheet formed as described above as required for protecting the surface of the resin composition sheet, and the release sheet may be released at the time of encapsulation.

As the organic solvent to be used in the preparation of the varnish, there may be used, for example, methyl ethyl ketone, acetone, cyclohexanone, dioxane, diethyl ketone, toluene, or ethyl acetate. One kind of those solvents is used alone, or two or more kinds thereof are used in combination. In addition, in ordinary cases, the organic solvent is preferably used so that the solid content concentration of the varnish may fall within the range of 30 to 60 wt%.

In addition, when the sheet is produced by extrusion molding, the sheet can be produced by, for example, melting and kneading the materials therefor with a kneader or the like (typically kneading at 30 to 150°C for 1 to 30 minutes) to prepare the resin composition, and extruding the composition into a sheet shape by a flat-plate pressing method, a T-die extrusion method, a roll milling method, a roll kneading method, an inflation extrusion method, a co-extrusion method, a calendering method, or the like without cooling the composition.

The thickness of the sheet obtained as described above needs to be set within the range of 20 to 200 µm from the viewpoint of securing desired encapsulation property. The thickness is set within the range of preferably 40 to 150 µm, more preferably 60 to 120 µm. That is because of the following reasons. When the thickness of the sheet falls short of the range, sufficient encapsulation property is not obtained. In contrast, when the thickness of the sheet outstrips the range, the sheet is poor in unevenness followability with respect to a mounted substrate in which electronic parts having various heights are simultaneously present.

It should be noted that the sheet may be laminated before use as required in order that the thickness described above may be obtained. That is, a laminate of two or more layers as well as a sheet of a monolayer structure may be used as the sheet.

In addition, the sheet preferably has a tensile elongation rate in the range of 20 to 300% and a tensile strength in the range of 1 to 20 (N/20 mm) in an uncured state at 25°C from such a viewpoint that additionally good encapsulation property and additionally good unevenness followability are obtained. It should be noted that the tensile elongation rate and the tensile strength are measured in conformity with JIS K 6251.

In addition, a resin encapsulation step in a method of producing an electronic part apparatus using the sheet is performed as illustrated in, for example, FIGS. 1A and 1B and FIGS. 2A and 2B.

That is, first, as illustrated in FIG. 1A, a sheet 6 (the resin composition sheet for encapsulating electronic parts) is loaded on a circuit substrate 3 on which electronic parts 5a, 5b, and 5c having different heights are mounted. At that time, the sheet 6 is loaded so as to cover the upper surfaces of the electronic parts 5a, 5b, and 5c. It should be noted that in the figure, reference numeral 1 represents a chamber lid, reference numeral 2 represents a chamber, and reference numeral 4 represents a base.

Next, as illustrated in FIG. 1B, the chamber lid 1 is moved to enclose the inside of the chamber 2. After that, the inside of the chamber 2 is brought into a decompressed state (deaerated in a direction indicated by an arrow illustrated in the figure) and then the inside of the chamber 2 is heated. Thus, the sheet 6 thermally softens and hence, as illustrated in FIG. 2A, the end portion of the perimeter of the sheet 6 sags until the end portion is in contact with the surface of the circuit substrate 3. It should be noted that the heating of the inside of the chamber 2 is preferably performed at a temperature of 50 to 150°C in order that such state as illustrated in FIG. 2A may be established. In addition, a pressure in the chamber 2 is preferably reduced to fall within the range of 0.01 to 5 kPa from the viewpoint of favorably advancing the step.

Then, as illustrated in FIG. 2A, a space surrounded with the perimeter of the sheet 6 is enclosed by the sagging of the sheet 6, and hence a state where the sheet 6 covers the electronic parts 5a, 5b, and 5c is established. At this time, as illustrated in the figure, the sheet 6 forms an enclosed space 7 between itself and a mounted substrate (the circuit substrate 3, and the electronic parts 5a, 5b, and 5c) as a result of the covering.

When the pressure in the chamber 2 is released by the movement of the chamber lid 1 in the state as illustrated in FIG. 2B, the sheet 6 is caused to closely adhere onto the mounted substrate by a difference between the pressure in the enclosed space 7 formed between the sheet 6 and the mounted substrate, and the pressure in the chamber 2 after the release, thereby encapsulating the electronic parts 5a, 5b, and 5c. After that, an encapsulating resin layer 8 formed of a cured body of the sheet 6 is formed by heating the sheet to the temperature at which the sheet thermally cures (a temperature exceeding 150°C, preferably a thermosetting temperature of 155 to 185°C). Thus, an electronic part apparatus obtained by encapsulating the plurality of electronic parts 5a, 5b, and 5c on the circuit substrate 3 with the resin can be obtained. It should be noted that a heating time for the thermal curing is preferably 1 to 3 hours in order that the thermal curing may be advanced quickly and completely.

Thus, the electronic part apparatus is obtained through the resin encapsulation step. However, when the electronic part apparatus after the encapsulation is an aggregate of electronic part apparatuses, the step of dicing the aggregate to provide individual electronic part apparatuses is needed. When the dicing is performed as described above, the individual electronic part apparateses us can be obtained by, for example, appropriately attaching a dicing tape to the resin-sealed surface of the electronic part apparatuses aggregate and dicing the resultant (not shown).

### EXAMPLES

Next, examples are described together with comparative examples, provided that the present invention is not limited to these examples as long as any other example does not deviate from the gist thereof.

First, prior to the examples and the comparative examples, the following materials were prepared.

### (Epoxy resin a)

Modified bisphenol A type epoxy resin (manufactured by DIC Corporation, EPICLON EXA-4850-150)

### (Epoxy resin b)

Triphenylmethane type epoxy resin (manufactured by Nippon Kayaku Co., Ltd., EPPN-501HY)

### (Epoxy resin c)

Bisphenol F type crystalline epoxy resin represented by the following structural formula:

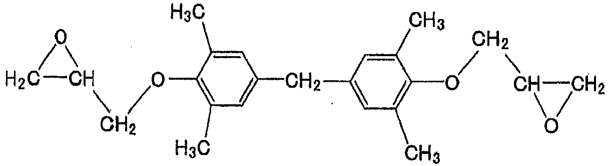

### (Phenolic resin a)

Novolac type phenol resin (manufactured by ARAKAWA CHEMICAL INDUSTRIES, LTD., P-200)

### (Phenolic resin b)

Biphenyl aralkyl type phenol resin (manufactured by Meiwa Plastic Industries, Ltd, MEH-7851SS)

### (Elastomer a)

An acrylic copolymer obtained by Synthesis Example 1 below (copolymer formed of butyl acrylate, acrylonitrile, and glycidyl methacrylate at a weight percent ratio of 85:8:7, weight-average molecular weight: 800,000)

### (Synthesis Example 1)

Butyl acrylate, acrylonitrile, and glycidyl methacrylate were loaded at a weight ratio of 85:8:7, and were then radically polymerized at 70°C for 5 hours and at 80°C for 1 hour in methyl ethyl ketone in a stream of nitrogen with 2,2'-azobisisobutyronitrile as a polymerization initiator. Thus, the acrylic copolymer was obtained.

### (Elastomer b)

Triblock copolymer formed of styrene-isobutylene-styrene skeleton

### (Curing accelerator)

2-Phenyl-4,5-dihydroxymethylimidazole represented by the following structural formula

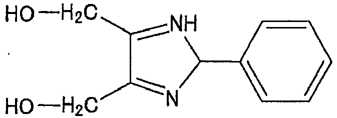

### (Inorganic filler a)

Synthetic silica having average particle diameter of 0.5 µm

### (Inorganic filler b)

Spherical molten silica having average particle diameter of 20 µm

### (Examples 1 to 3, 6, 7, 11, and 12, and Comparative Examples 1 to 4)

Varnishes for coating were each prepared by: dispersing and mixing respective components at a ratio shown in any one of Table 1 to Table 3 below; and adding, to the mixture, the same amount of methyl ethyl ketone as the total amount of the respective components.

Next, the top of the release-treated surface of a polyester film having a thickness of 38 µm (MRF-38 manufactured by Mitsubishi Plastics, Inc.) was coated with each of the varnishes with a comma coater and then the varnish was dried. Thus, sheets each having a thickness of 10 to 100 µm were obtained. With regard to a sheet having a thickness of 100 µm or more, a sheet having a desired thickness was obtained by laminating the sheets obtained here with a laminator.

### (Examples 4, 5, 8 to 10, and 13, and Comparative Examples 5 and 6)

Respective components were dispersed and mixed at a ratio shown in any one of Table 1 to Table 3 below, and then the mixture was melted and kneaded with a biaxial kneader at 120°C for 2 minutes, followed by extrusion from a T-die at a thickness of 1 mm. The extruded product was pressed with a flat-plate hot press at 100°C. Thus, a sheet having a desired thickness was obtained.

Table 1 to Table 3 below show the characteristics (sheet thickness (µm), lowest viscosity (Pa·s), tensile elongation rate (%), and tensile strength (N/20 mm)) of the sheets of the examples and the comparative examples thus obtained. It should be noted that the lowest viscosity, the tensile elongation rate, and the tensile strength were measured under the following conditions.

### (Lowest viscosity)

A disc-shaped sheet piece having a thickness of 1 mm and a diameter of 8 mm was cut out of each of the resultant sheets, and then the sheet piece was subjected to temperature increase measurement with a viscoelasticity-measuring apparatus (ARES manufactured by TA Instruments) at a rate of temperature increase of 10°C/min and a measuring frequency of 1 Hz from 40°C to 150°C. Its lowest storage viscosity value was defined as the lowest viscosity.

### (Tension test)

A slot-shaped sheet piece having a width of 20 mm was cut out of each of the resultant sheets, and then a tensile elongation rate (%) and a tensile strength (N/20 mm) upon tension of the sheet piece under a 25 °C environment at a chuck-to-chuck gap of 5 mm and a constant tension speed of 20 mm/min were measured with a viscoelasticity-measuring apparatus (RSA-3 manufactured by TA Instruments).

Next, an electronic part was sealed with each of the sheets of the examples and the comparative examples as described below. Then, an evaluation for encapsulation property was performed in accordance with the following criteria. Tables 1 to 3 below show the results together.

### (Encapsulation of electronic part)

Each of the resultant sheets (size: 140 mm×110 mm) was loaded on a circuit substrate on which a plurality of electronic parts such as a semiconductor package were mounted (size: 100 mm×70 mm, highest component height: 6 mm). The resultant was placed in a chamber and then a pressure in the chamber was reduced to a vacuum atmosphere (around 1.3 kPa). After that, the inside of the chamber was heated to 110°C. Thus, the sheet was sagged and hence the sheet was caused to closely adhere to the entire region of the upper surface of the substrate. After that, the pressure in the chamber was released. Subsequently, the sheet was thermally cured with a hot-air oven at 150°C for 1 hour. Thus, the electronic parts mounted on the circuit substrate were sealed with the resin (see FIGS. 1 and FIGS. 2).

### (Encapsulation property)

The external appearance of the mounted substrate (electronic part apparatus) after the encapsulation with the resin was observed with an optical microscope at a magnification of 30 and evaluated in accordance with the following criteria.
⊚: All the side surfaces and upper surfaces of the electronic parts on the circuit substrate are covered with the resin (sheet), and the resin closely adheres to an entire region on the substrate.
○: All the side surfaces and upper surfaces of the electronic parts on the circuit substrate are covered with the resin (sheet), but part of the edges of the electronic parts are exposed. Alternatively, all the side surfaces and upper surfaces of the electronic parts on the circuit substrate are covered with the resin (sheet), but the resin does not closely adhere in part of the regions on the substrate between the electronic parts.
×: The resin (sheet) is not in contact with some regions of the side surfaces and upper surfaces of the electronic parts on the circuit substrate (with regard to the substrate in which resin breakage or an encapsulation failure is observed, words to that effect are described in any one of the tables below).

**[Table 1]**

| <<Part(s) by weight>> | | | | | | | |
|---|---|---|---|---|---|---|---|
| | Example | | | | | | |
| | 1 | 2 | 3 | 4 | 5 | 6 | 7 |
| Epoxy resin (a) | 6 | 6 | 6 | - | - | 6 | 6 |
| Epoxy resin (b) | 2.5 | 2.5 | 2.5 | - | - | 2.5 | 2.5 |
| Epoxy resin (c) | - | - | - | 4.1 | 4.1 | - | - |
| Phenol resin (a) | 3 | 3 | 3 | - | - | 3 | 3 |
| Phenol resin (b) | - | - | - | 4.2 | 4.2 | - | - |
| Elastomer (a) | 27 | 27 | 27 | - | - | 27 | 27 |
| Elastomer (b) | - | - | - | 3.6 | 3.6 | - | - |
| Curing accelerator | 1.5 | 1.5 | 1.5 | 0.1 | 0.1 | 1.5 | 1.5 |
| Inorganic filler (a) | 60 | 60 | 60 | - | - | 60 | 60 |
| Inorganic filler (b) | - | - | - | 88 | 88 | - | - |
| Sheet thickness (µm) | 100 | 150 | 30 | 100 | 150 | 20 | 200 |
| Lowest viscosity (Pa·s) | 15,000 | 15,000 | 15,000 | 800 | 800 | 15,000 | 15,000 |
| Tensile elongation rate (%) | 50 | 95 | 23 | 22 | 52 | 21 | 160 |
| Tensile strength (N/20 mm) | 3.2 | 5.5 | 1.4 | 10.0 | 18.2 | 1.1 | 95 |
| Encapsulation property | ⊚ | ⊚ | ⊚ | ⊚ | ⊚ | ⊚ | ⊚ |

**[Table 2]**

| <<Part(s) by weight>> | | | | | | |
|---|---|---|---|---|---|---|
| | Example | | | | | |
| | 8 | 9 | 10 | 11 | 12 | 13 |
| Epoxy resin (a) | - | - | - | 5.1 | 9.7 | - |
| Epoxy resin (b) | - | - | - | 2.1 | 4.0 | - |
| Epoxy resin (c) | 5.0 | 3.2 | 4.4 | - | - | 4.1 |
| Phenol resin (a) | - | - | - | 2.5 | 4.8 | - |
| Phenol resin (b) | 5.1 | 3.3 | 4.6 | - | - | 4.2 |
| Elastomer (a) | - | - | - | 28.8 | 20.0 | - |
| Elastomer (b) | 1.8 | 5.4 | 2.9 | - | - | 3.6 |
| Curing accelerator | 0.1 | 0.1 | 0.1 | 1.5 | 1.5 | 0.1 |
| Inorganic filler (a) | - | - | - | 60 | 60 | - |
| Inorganic filler (b) | 88 | 88 | 88 | - | - | 88 |
| Sheet thickness (µm) | 180 | 100 | 100 | 150 | 25 | 180 |
| Lowest viscosity (Pa·s) | 100 | 20,000 | 500 | 19,000 | 11,000 | 800 |
| Tensile elongation rate (%) | 25 | 90 | 20 | 300 | 21 | 65 |
| Tensile strength (N/20 mm) | 15 | 7.6 | 1.2 | 15.5 | 1 | 20 |
| Encapsulation property | ○ | ○ | ⊚ | ○ | ⊚ | ⊚ |

**[Table 3]**

| <<Part(s) by weight>> | | | | | | |
|---|---|---|---|---|---|---|
| | Comparative Example | | | | | |
| | 1 | 2 | 3 | 4 | 5 | 6 |
| Epoxy resin (a) | 6 | 6 | 4 | 4 | - | - |
| Epoxy resin (b) | 2.5 | 2.5 | 1.5 | 1.5 | - | - |
| Epoxy resin (c) | - | - | - | - | 4.1 | 5.4 |
| Phenol resin (a) | 3 | 3 | 2 | 2 | - | - |
| Phenol resin (b) | - | - | - | - | 4.2 | 5.5 |
| Elastomer (a) | 2.7 | 27 | 21.5 | 21.5 | - | - |
| Elastomer (b) | - | - | - | - | 3.6 | 1 |
| Curing accelerator | 1.5 | 1.5 | 1 | 1 | 0.1 | 0.1 |
| Inorganic filler (a) | 60 | 60 | 70 | 70 | - | - |
| Inorganic filler (b) | - | - | - | - | 88 | 88 |
| Sheet thickness (µm) | 15 | 250 | 100 | 30 | 250 | 100 |
| Lowest viscosity (Pa·s) | 15,000 | 15,000 | 35,000 | 35,000 | 800 | 80 |
| Tensile elongation rate (%) | 12 | 330 | 14 | 5 | 110 | 25 |
| Tensile strength (N/20 mm) | 0.7 | 9.8 | 4.2 | 0.5 | 32.5 | 12.0 |
| Encapsulation property | ×^{*1} | ×^{*2} | ×⁺² | ×^{*2} | ×^{*2} | ×^{*1} |

| | | | | | | |
|---|---|---|---|---|---|---|
| ^{*1}: Resin breakage ^{*2}: Encapsulation failure | | | | | | |

It is understood from the results of the tables that in each of the examples, good encapsulation was performed even on a mounted substrate having large unevenness without any pressing step because resin encapsulation was performed with a sheet whose lowest viscosity and sheet thickness fell within the ranges specified in the present invention.

In contrast, in each of the comparative examples, resin encapsulation was performed with a sheet whose lowest viscosity or sheet thickness deviated from the range specified in the present invention. Accordingly, the unevenness followability of the sheet was poor, and a portion in a state where the sheet was not in contact with the upper surface or side surface of an electronic part was observed. Resin breakage or an encapsulation failure was also observed.

Although specific forms of embodiments of the instant invention have been described above and illustrated in the accompanying drawings in order to be more clearly understood, the above description is made by way of example and not as a limitation to the scope of the instant invention. It is contemplated that various modifications apparent to one of ordinary skill in the art could be made without departing from the scope of the invention.

## Claims

1. A resin composition sheet for encapsulating electronic parts, comprising:
a thermosetting resin composition comprising
an epoxy resin,
a phenol resin,
an inorganic filler, and
a curing accelerator,
wherein the thermosetting resin composition has a lowest viscosity in temperature increase measurement with a viscoelasticity-measuring apparatus in a range of 100 to 20,000 Pa·s, as measured at a temperature range of 40°C to 150°C, and
wherein the sheet has a thickness in a range of 20 to 200 µm.

2. The resin composition sheet for encapsulating electronic parts according to claim 1, wherein the sheet has a tensile elongation rate in a range of 20 to 300% and a tensile strength in a range of 1 to 20 (N/20 mm) in an uncured state at 25°C.

3. A method of producing an electronic part apparatus, comprising:
arranging and mounting a plurality of electronic components on a circuit substrate to provide a mounted substrate, followed by loading of a resin composition sheet in a state where the sheet covers upper surfaces of the electronic parts;
heating the mounted substrate in a chamber in a decompressed state to sag an end portion of a perimeter of the sheet through thermal softening until the end portion is in contact with a surface of the substrate to enclose a space surrounded with the perimeter of the sheet;
releasing a pressure in the chamber to cause the sheet to closely adhere onto the mounted substrate due to a difference between (i) a pressure in the enclosed space formed between the sheet and the mounted substrate, and (ii) the pressure in the chamber after the release, to seal the electronic parts; and
thermally curing the sheet after the encapsulation,
wherein the resin composition sheet comprises a thermosetting resin composition comprising:
an epoxy resin,
a phenol resin,
an inorganic filler, and
a curing accelerator,
wherein the thermosetting resin composition has a lowest viscosity in temperature increase measurement with a viscoelasticity-measuring apparatus in a range of 100 to 20,000 Pa·s, as measured at a temperature range of 40°C to 150°C, and
wherein the sheet having a thickness in a range of 20 to 200 µm.

4. The method of producing an electronic part apparatus according to claim 3, wherein the sheet has a tensile elongation rate in a range of 20 to 300% and a tensile strength in a range of 1 to 20 (N/20 mm) in an uncured state at 25°C.

5. The method of producing an electronic part apparatus according to claim 3 or 4, wherein the heating in the chamber in the decompressed state is performed at a temperature of 50 to 150°C.

6. The method of producing an electronic part apparatus according to any one of claims 3 to 5, wherein the electronic part apparatus after the encapsulation comprises an aggregate of electronic part apparatuses, and the method further comprises dicing the aggregate to provide individual electronic part apparatuses.

7. The method of producing an electronic part apparatus according to any one of claims 3 to 6, wherein the chamber in decompressed state has a pressure of 0.01 to 5 kPa.

8. An electronic part apparatus obtainable according to any one of the methods of claims 3-7

## Patentansprüche

1. Harzzusammensetzungsfolie zum Verkapseln elektronischer Bauteile, umfassend:
eine wärmehärtbare Harzzusammensetzung, umfassend:
ein Epoxidharz,
ein Phenolharz,
einen anorganischen Füllstoff und
einen Aushärtungsbeschleuniger,
worin die wärmehärtbare Harzzusammensetzung eine kleinste Viskosität bei Temperaturerhöhungsmessung mit einer Viskoelastizität-messenden Vorrichtung im Bereich von 100 bis 20.000 Pa·s aufweist, gemessen in einem Temperaturbereich von 40°C bis 150°C, und
worin die Folie eine Dicke im Bereich von 20 bis 200 µm aufweist.

2. Harzzusammensetzungsfolie zum Verkapseln elektronischer Bauteile gemäß Anspruch 1, worin die Folie einen Zugdehnungsgrad im Bereich von 20 bis 300 % und eine Zugfestigkeit im Bereich von 1 bis 20 (N/20 mm) im ungehärteten Zustand bei 25°C aufweist.

3. Verfahren zur Herstellung einer Vorrichtung aus elektronischen Bauteilen, umfassend:
Anordnen und Montieren einer Mehrzahl elektronischer Komponenten auf einem Schaltkreissubstrat, um ein montiertes Substrat bereitzustellen, gefolgt von Beschicken mit einer Harzzusammensetzungsfolie in einem Zustand, in dem die Folie obere Oberflächen der elektronischen Bauteile bedeckt;
Erwärmen des montierten Substrats in einer Kammer in einem dekomprimierten Zustand, um einen Endbereich der Umfangslänge der Folie durch thermische Erweichung zu biegen, bis sich der Endbereich in Kontakt mit der Oberfläche des Substrats befindet, um einen Raum einzuschließen, der von der Umfangslänge der Folie umgeben ist;
Ablassen von Druck in der Kammer, um eine enge Haftung der Folie auf dem montierten Substrat aufgrund eines Unterschieds zwischen (i) dem Druck in dem eingeschlossenen Raum, der zwischen der Folie und dem montierten Substrat gebildet wird, und (ii) dem Druck in der Kammer nach dem Ablassen hervorzurufen, um die elektronischen Bauteile zu versiegeln; und
thermisches Härten der Folie nach der Verkapselung,
worin die Harzzusammensetzungsfolie eine wärmehärtbare Harzzusammensetzung umfasst, umfassend:
ein Epoxidharz,
ein Phenolharz,
einen anorganischen Füllstoff und
einen Aushärtungsbeschleuniger,
worin die wärmehärtbare Harzzusammensetzung eine kleinste Viskosität bei einer Temperaturerhöhungsmessung mit einer Viskoelastizität-messenden Vorrichtung im Bereich von 100 bis 20.000 Pa·s aufweist, gemessen in einem Temperaturbereich von 40°C bis 150°C, und
worin die Folie eine Dicke im Bereich von 20 bis 200 µm aufweist.

4. Verfahren zur Herstellung einer Vorrichtung aus elektronischen Bauteilen gemäß Anspruch 3, worin die Folie einen Zugdehnungsgrad im Bereich von 20 bis 300 % und eine Zugfestigkeit im Bereich von 1 bis 20 (N/20 mm) im ungehärteten Zustand bei 25°C aufweist.

5. Verfahren zur Herstellung einer Vorrichtung aus elektronischen Bauteilen gemäß Anspruch 3 oder 4, worin die Erwärmung in der Kammer im dekomprimierten Zustand bei einer Temperatur von 50 bis 150°C durchgeführt wird.

6. Verfahren zur Herstellung einer Vorrichtung aus elektronischen Bauteilen gemäß einem der Ansprüche 3 bis 5, worin die Vorrichtung aus elektronischen Bauteilen nach der Verkapselung eine Ansammlung von Vorrichtungen aus elektronischen Bauteilen umfasst und das Verfahren ferner das Zerschneiden der Ansammlung umfasst, um einzelne Vorrichtungen aus elektronischen Bauteilen bereitzustellen.

7. Verfahren zur Herstellung einer Vorrichtung aus elektronischen Bauteilen gemäß einem der Ansprüche 3 bis 6, worin die Kammer im dekomprimierten Zustand einen Druck von 0,01 bis 5 kPa aufweist.

8. Vorrichtung aus elektronischen Bauteilen, die erhältlich ist gemäß einem der Verfahren der Ansprüche 3 bis 7.

## Revendications

1. Feuille de composition de résine pour l'encapsulation de pièces électroniques, comprenant :
une composition de résine thermodurcissable comprenant une résine époxy,
une résine phénolique,
une charge inorganique, et
un accélérateur de durcissement,
dans laquelle la composition de résine thermodurcissable a une viscosité la plus faible lors d'une mesure d'élévation de température avec un appareil de mesure de viscoélasticité dans une plage allant de 100 à 20000 Pa·s, telle que mesurée à une plage de température allant de 40°C à 150°C, et
dans laquelle la feuille a une épaisseur dans une plage allant de 20 à 200 µm.

2. Feuille de composition de résine pour l'encapsulation de pièces électroniques selon la revendication 1, dans laquelle la feuille a un taux d'allongement par traction dans une plage allant de 20 à 300% et une résistance à la traction dans une plage allant de 1 à 20 (N/20 mm) dans un état non durci à 25°C.

3. Procédé de production d'un appareil de pièces électroniques, comprenant :
l'agencement et le montage d'une pluralité de composants électroniques sur un substrat de circuit pour fournir un substrat monté, suivis par le chargement d'une feuille de composition de résine dans un état où la feuille recouvre des surfaces supérieures des pièces électroniques ;
le chauffage du substrat monté dans une chambre dans un état décomprimé pour fléchir une partie d'extrémité d'un périmètre de la feuille par ramollissement thermique jusqu'à ce que la partie d'extrémité soit en contact avec une surface du substrat pour enfermer un espace entouré avec le périmètre de la feuille ;
la libération d'une pression dans la chambre pour amener la feuille à adhérer étroitement sur le substrat monté en raison d'une différence entre (i) une pression dans l'espace enfermé formé entre la feuille et le substrat monté, et (ii) la pression dans la chambre après la libération, pour sceller les pièces électroniques ; et
le durcissement thermique de la feuille après l'encapsulation,
dans lequel la feuille de composition de résine comprend une composition de résine thermodurcissable comprenant :
une résine époxy,
une résine phénolique,
une charge inorganique, et
un accélérateur de durcissement,
où la composition de résine thermodurcissable a une viscosité la plus faible lors d'une mesure d'élévation de température avec un appareil de mesure de viscoélasticité dans une plage allant de 100 à 20000 Pa·s, telle que mesurée à une plage de température allant de 40°C à 150°C, et
où la feuille ayant une épaisseur dans une plage allant de 20 à 200 µm.

4. Procédé de production d'un appareil de pièces électroniques selon la revendication 3, dans lequel la feuille a un taux d'allongement par traction dans une plage allant de 20 à 300% et une résistance à la traction dans une plage allant de 1 à 20 (N/20 mm) dans un état non durci à 25°C.

5. Procédé de production d'un appareil de pièces électroniques selon la revendication 3 ou 4, dans lequel le chauffage dans la chambre dans l'état décomprimé est effectué à une température allant de 50 à 150°C.

6. Procédé de production d'un appareil de pièces électroniques selon l'une quelconque des revendications 3 à 5, dans lequel l'appareil de pièces électroniques après l'encapsulation comprend un agrégat d'appareils de pièces électroniques, et le procédé comprend en outre le découpage en dès de l'agrégat pour fournir des appareils de pièces électroniques individuels.

7. Procédé de production d'un appareil de pièces électroniques selon l'une quelconque des revendications 3 à 6, dans lequel la chambre dans l'état décomprimé a une pression allant de 0,01 à 5 kPa.

8. Appareil de pièces électroniques pouvant être obtenu selon l'une quelconque des procédés des revendications 3 à 7.
